Europäisches Patentamt

European Patent Office

Office européen des brevets

(11) Veröffentlichungsnummer: **0 348 650**
**A1**

## (12) EUROPÄISCHE PATENTANMELDUNG

(21) Anmeldenummer: **89108778.5**

(22) Anmeldetag: **16.05.89**

(51) Int. Cl.⁴: **H01L 39/24 , C04B 35/00**

(30) Priorität: **26.05.88 DE 3817934**

(43) Veröffentlichungstag der Anmeldung:
**03.01.90 Patentblatt 90/01**

(84) Benannte Vertragsstaaten:
**CH DE FR GB IT LI NL SE**

(71) Anmelder: **Siemens Aktiengesellschaft**
**Wittelsbacherplatz 2**
**D-8000 München 2(DE)**

(72) Erfinder: **Hofer, Gerhard, Dr.**
**Hauptstrasse 1**
**D-8551 Röttenbach(DE)**

(54) **Verfahren und Einrichtung zum Herstellen von texturierten oxidischen Hochtemperatur-Supraleitern.**

(57) Die Erfindung betrifft ein Verfahren und eine Einrichtung zum Texturieren von hochtemperatur-supraleitendem Material (3, 15) in einer Sauerstoff enthaltenden Atmosphäre. Es ist vorgesehen, daß der Sauerstoffpartialdruck dem zum Texturieren notwendigen Temperaturverlauf nachgeführt wird. Insbesondere erfolgt das Texturieren in einem abgeschlossenen Behälter (1, 6) mit konstantem Volumen, in dem sich eine bestimmte Sauerstoffmenge befindet, deren Partialdruck sich mit der Temperatur verändert. Zum Beheizen weist der Behälter (1, 6) beispielsweise ein Fenster (2, 7) auf, durch das hindurch Laserlicht in den Behälter (1, 6) gelangt. Das zu texturierende Material (3, 15) kann zusätzlich durch eine heizbare und/oder kühlbare Platte (12, 13) auf beliebiger Temperatur gehalten werden.

FIG 1

EP 0 348 650 A1

## Verfahren und Einrichtung zum Herstellen von texturierten oxidischen Hochtemperatur-Supraleitern

Die Erfindung betrifft ein Verfahren zum Texturieren von hochtemperatur-supraleitendem oxidischen Material in einer Sauerstoff enthaltenden Atmosphäre. Sie betrifft weiter eine Einrichtung zur Durchführung des Verfahrens.

Es sind oxidische Supraleiter bekannt, die sich durch eine hohe Sprungtemperatur auszeichnen. Derartige Oxide haben beispielsweise die Zusammensetzung:

$$Ma_1\ Mb_2\ Cu_3\ O_{6,5\pm x} \qquad (1).$$

Dabei ist Ma eine seltene Erde, wie Yttrium, Lanthan oder ein Lanthanid, Mb ist ein Erdalkalimetall, wie Barium oder Strontium, Cu ist Kupfer, O ist Sauerstoff, die Zahlen 1, 2, 3 und 6,5 sind Verhältniszahlen, und x ist ein Wert zwischen 0,25 und 0,50. Die oxidischen Supraleiter mit hoher Sprungtemperatur haben in gesinterter Form eine sehr niedrige Stromtragfähigkeit. Eine hohe Stromtragfähigkeit wird hingegen in einer dünnen Schicht auf einem Substrat oder in einem auf einen Träger aufgebrachten Film erzielt, in denen eine starke Ausrichtung der kristallographischen c-Achsen des supraleitenden Materials senkrecht zur Substrat- bzw. Filmoberfläche gegeben ist.

In massiven, dickeren Teilen aus supraleitendem Material kann jedoch eine Erhöhung der Stromtragfähigkeit erreicht werden, falls ein entsprechendes Ausrichten der Kristallite bewirkt wird.

Ein Supraleiter soll einerseits eine hohe Sprungtemperatur und andererseits eine hohe Stromtragfähigkeit besitzen. Um einen solchen Supraleiter herzustellen, ist beim Herstellungsverfahren auf eine richtige Zusammensetzung des Oxides, auf eine Beschränkung auf möglichst wenige Korngrenzen und auf eine Ausrichtung der Kristallite mit ihren orthorhombischen c-Achsen senkrecht zum Substrat zu achten. Diese Ausrichtung der Kristallite wird hier mit "Texturierung" oder "Texturieren" bezeichnet.

Die Erfindung beruht auf folgender Überlegung: Zum Texturieren von hochtemperatur-supraleitendem Material auf einem Substrat ist ein thermodynamischer Weg besonders geeignet. Dabei wird beispielsweise ein geeignetes Oxidpulver, dessen x-Wert in der oben angegebenen Formel (1) zwischen 0,25 und 0,50 liegt, in einer sauerstoffhaltigen Umgebung zunehmend erhitzt. Dabei ist bei niedrigen Temperaturen, z.B. bei Zimmertemperatur, ein Sauerstoffpartialdruck, der unter 1 Pa ($10^{-5}$ at) liegt, erforderlich. Bei Erreichen einer Temperatur von 600°C bis 700°C ist bereits ein Sauerstoffpartialdruck von $10^5$ Pa (1 at) erforderlich. Sodann erfolgt eine Erwärmung des Materials bis in den Schmelzbereich auf etwa 1150°C bis 1200°C und eine anschließende Abkühlung. Dabei ist eine ständige Veränderung des Sauerstoffpartialdruckes der umgebenden Atmosphäre notwendig. Eine eine hohe Genauigkeit erfordernde Regelung des Sauerstoffpartialdruckes neben der Temperaturregelung wäre nur mit aufwendigen Mitteln ausreichend genau durchführbar. Dazu wären die Sauerstoffzufuhr und die Gasableitung zu regeln.

Der Erfindung liegt die Aufgabe zugrunde, ein Verfahren zum Texturieren von hochtemperatur-supraleitendem Material anzugeben, das ohne aufwendige Regelung der Sauerstoffzufuhr und der Gasableitung auskommt. Weiterhin soll eine Einrichtung zur Durchführung des Verfahrens angegeben werden.

Die erstgenannte Aufgabe wird erfindungsgemäß dadurch gelöst, daß der Sauerstoffpartialdruck dem zum Texturieren notwendigen Temperaturverlauf nachgeführt wird.

Nach einmaligem Festlegen derjenigen Temperatur-Druck-Beziehung, die eine optimale Texturierung ermöglicht (optimale Temperatur - Druck - Beziehung), wird der Sauerstoffpartialdruck allein in Abhängigkeit von der Temperatur geführt.

Mit dieser Nachführung ist in kurzer Zeit eine gute Texturierung durchführbar.

Gemäß einer Weiterentwicklung des erfindungsgemäßen Verfahrens ist vorgesehen, daß das Texturieren des hochtemperatur-supraleitenden Materials in einem abgeschlossenen Behälter von konstantem Volumen erfolgt. In diesem Behälter befindet sich eine bestimmte, vorgegebene Sauerstoffmenge, deren Partialdruck sich mit der Temperatur verändert.

Ausgehend von einem Sauerstoffpartialdruck unter 1 Pa ($10^{-5}$ at) stellt sich in dem abgeschlossenen Volumen des Behälters bei Erwärmung und bei späterer Abkühlung der notwendige Gleichgewichts-Sauerstoffpartialdruck ein, da das Volumen des Behälters konstant ist.

Bei dieser Weiterentwicklung wird der Vorteil erzielt, daß eine Regelung eines zuzuführenden Gasstroms und eine Regelung eines abzuführenden Gasstroms nicht erforderlich sind. Wird eine Temperaturänderung vorgenommen, so wird durch das Aufheizen oder Abkühlen der Gasmenge im abgeschlossenen Volumen und durch die vom Material aufgenommenen oder abgegebenen Sauerstoffmengen die erforderliche Änderung des Sauerstoffpartialdruckes bewirkt. Das Verfahren zum Texturieren des hochtemperatur-supraleitenden Materials kommt während des gesamten Verfahrensablaufes völlig ohne Regelung des Druckes im Texturierbehälter durch Zuführen oder Ablassen von Gasen aus.

Das Erhitzen des zu texturierenden Materials wird beispielsweise durch Laserlicht bewirkt; es ist aber auch eine andersartige Erwärmung des im Behälter befindlichen Materials möglich.

Das Laserlicht gelangt beispielsweise von außen durch ein Fenster in den abgeschlossenen Behälter. Damit erzielt man den Vorteil, daß z.B. elektrische Zuleitungen, die in den Behälter führen, zum Erhitzen prinzipiell nicht benötigt werden. Solche Zuleitungen würden gasdichte Durchführungen durch die Behälterwand erfordern.

Ergänzend kann allerdings eine Zusatzheizung, z.B. eine elektrische Zusatzheizung, zur Einstellung einer beliebigen Grundtemperatur vorgesehen sein. Weiterhin ist beispielsweise eine Kühlvorrichtung vorhanden.

Zum Texturieren wird das Material beispielsweise zuerst auf eine Temperatur zwischen 850° C und 900° C erhitzt, dann kurzzeitig zum Schmelzen gebracht, anschließend 1 h bis 1,5 h lang bei etwa 900° C geglüht und abschließend langsam auf Zimmertemperatur abgekühlt. Damit erzielt man eine gute Texturierung.

Bei der Erwärmung des Materials und gegebenenfalls auch beim erwähnten kurzzeitigen Aufschmelzen wird Sauerstoff vom Material abgegeben. Beim Abkühlen nimmt das Material wieder Sauerstoff auf. In einem abgeschlossenen Behälter deckt das abgegebene Sauerstoffvolumen den späteren Sauerstoffbedarf.

Eine Einrichtung zum Durchführen des Verfahrens ist erfindungsgemäß gekennzeichnet durch einen gasdicht verschließbaren, beheizbaren Behälter oder eine Kammer mit konstantem Volumen, in den ein hochtemperatur-supraleitendes Material anzuordnen ist und der mit einem Gas, das eine bestimmte Sauerstoffmenge enthält, füllbar ist. Diese Sauerstoffmenge bewirkt einen Anfangs-Sauerstoffpartialdruck; der Sauerstoffpartialdruck wird dann allein durch Erwärmen und Abkühlen des Gases und des Materials im Behälter den Erfordernissen angepaßt, erhöht oder abgesenkt. In der Kammer befindet sich das zum Supraleiter zu texturierende Oxid zum Beispiel auf einem Substrat, das auf einer heizbaren und/oder kühlbaren Platte angeordnet ist.

Der anfangs geringe Sauerstoffpartialdruck, der kleiner als 1 Pa ($10^{-5}$ at) ist, reicht aus, um bei einer Erwärmung auf über 600° C einen Sauerstoffpartialdruck, der über $10^5$ Pa (1 at) beträgt, im konstanten Volumen der geschlossenen Kammer zu erzeugen, weil das oxidhaltige zu texturierende Material während der Erwärmung stark Sauerstoff abgibt.

Soll ein langgestreckter Körper, beispielsweise ein Rohr, das ein hochtemperatur-supraleitendes Material aufweist, texturiert werden, ist eine besondere Ausführungsform der Einrichtung vorgesehen. Dabei weist der Behälter zwei gegenüberliegend in Wänden angeordnete abdichtbare Öffnungen auf, durch die hindurch der Körper durch den Behälter hindurchführbar ist. In den Öffnungen sind Dichtungen angeordnet zur gasdichten Abdichtung des Behälters gegen den Körper. Im Behälter ist zum Beispiel eine heizbare und/oder kühlbare Platte angeordnet, über die hinweg der Körper zu bewegen ist.

Hiermit wird der Vorteil erzielt, daß selbst ein sehr langgestreckter Körper oder ein Bauteil, wie ein Rohr, auf einfache Weise kontinuierlich abschnittsweise zu texturieren ist. Wegen der gasdichten Durchführungen in den Wänden des Behälters ist bei eingebrachtem Körper ein Entweichen der Gasatmosphäre aus dem Behälter und damit ein Absinken des Sauerstoffpartialdrucks ausgeschlossen.

Zum Einstrahlen des Laserlichtes in den Behälter weist dieser beispielsweise ein in der Wand angeordnetes Fenster auf. Dadurch kommt man vorteilhafterweise ohne Leitungsdurchführungen aus, die andernfalls durch die Wände des Behälters für eine Heizeinrichtung hindurchgeführt werden müßten.

Beispielsweise ist der durch den Behälter hindurchzuführende langgestreckte Körper ein Rohr, auf dessen Innenoberfläche sich die zu texturierende Oxidschicht befindet. Der bei der Erwärmung der Oxidschicht abgegebene Sauerstoff diffundiert zum Teil durch die Rohrwand in den Behälter. Eine andere Teilmenge des Sauerstoffs fließt aber durch das Rohr ab. Damit bei der Abkühlung der Oxidschicht im Rohr ein ausreichender Sauerstoffpartialdruck gegeben ist, ist beispielsweise im Behälter eine Sauerstoff abgebende Substanz vorhanden. Der dort abgegebene Sauerstoff diffundiert in das Rohr hinein, so daß dort ein ausreichender Sauerstoffpartialdruck gegeben ist. Die Sauerstoff abgebende Substanz kann z.B. ein Oxid nach der Formel (1) sein, das jedoch so gelagert sein muß, daß es mit dem Rohr nicht in Berührung kommen kann. Eine Verbindung der Sauerstoff abgebenden Substanz mit dem Rohr darf nicht erfolgen. Dazu ist die Substanz auf einer Trageplatte gelagert. Im Behälter auf der Trageplatte gelagertes Oxid nach Formel (1) gibt bei der Erwärmung Sauerstoff in den Behälter ab, der dann bei der Abkühlung des Rohres zur Verfügung steht. Die Oxidmenge kann so bemessen sein, daß die durch das Rohr abgeflossene Sauerstoffmenge ersetzt wird.

Mit dem erfindungsgemäßen Verfahren und der erfindungsgemäßen Einrichtung zur Durchführung dieses Verfahrens wird insbesondere der Vorteil erzielt, daß eine gute Texturierung ohne aufwendige Regelung des Sauerstoffpartialdruckes durchführbar ist.

Die Erfindung wird an Ausführungsbeispielen anhand der Zeichnung näher erläutert:

FIG 1 zeigt eine Einrichtung zur Durchführung des Verfahrens nach der Erfindung.

FIG 2 zeigt eine weitere Einrichtung zur Durchführung des erfindungsgemäßen Verfahrens, wobei der Belag eines langgestreckten Körpers, beispielsweise eines Rohres, zu texturieren ist.

FIG 3 zeigt einen möglichen zeitlichen Temperaturverlauf beim Texturieren gemäß dem Verfahren nach der Erfindung.

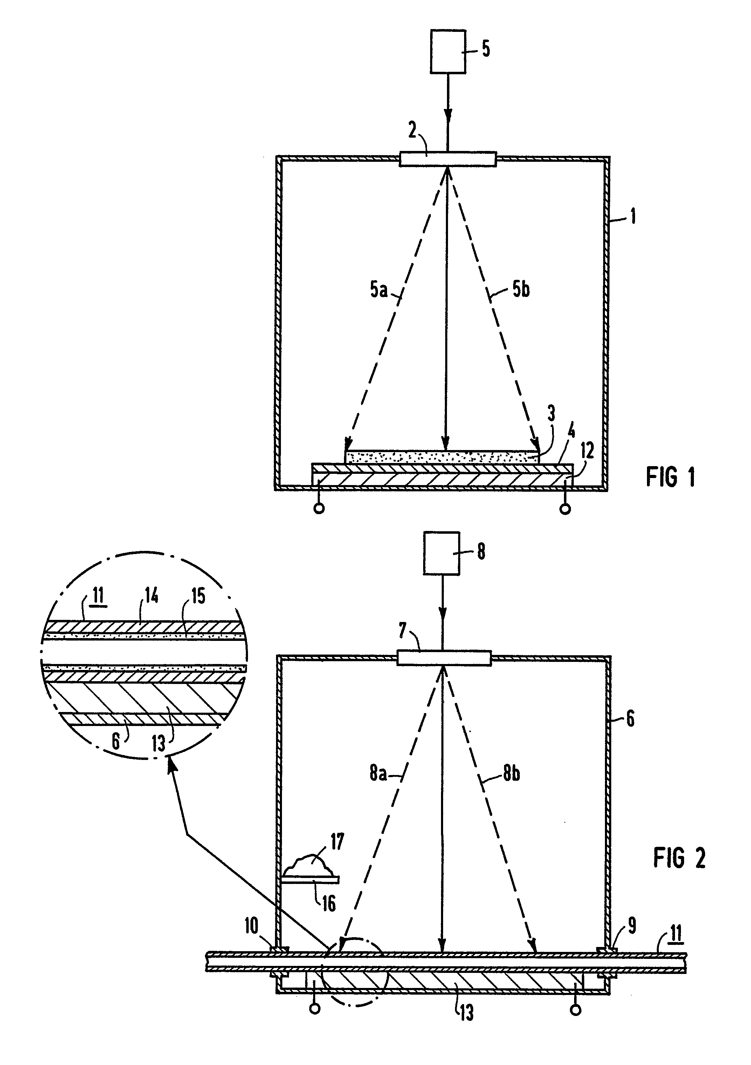

Die Einrichtung zum Texturieren von hochtemperatur-supraleitendem Material weist nach Figur 1 eine abgeschlossene Kammer oder einen allseitig geschlossenen Behälter 1 auf. In einer Wand des Behälters 1 ist ein Fenster 2 angeordnet. In dem Behälter 1 wird dem Fenster 2 gegenüber das für die Texturierung vorgesehene Oxid nach Formel (1) angeordnet. Das Oxid liegt z.B. als massiver Körper vor. Nach Figur 1 ist es jedoch als Oxidschicht 3 auf einem Substrat 4 aufgebracht. Ein Substrat 4 ist auch immer dann vorgesehen, wenn im Behälter 1 eine heizbare und/oder kühlbare Platte 12 angeordnet ist. Diese Platte 12 wird voll durch das Substrat 4 überdeckt, auf dem wiederum die Oxidschicht 3 angeordnet ist. Durch das Substrat 4 ist die Oxidschicht 3 vor einer direkten Berührung mit der Platte 12 geschützt, was andernfalls chemische Reaktionen zur Folge haben könnte.

Außerhalb des Behälters 1 ist in der Achse des Fensters 2 ein Laser 5 angeordnet. Zur Erwärmung der Oxidschicht 3 wird diese vom Laser 5 durch das Fenster 2 hindurch kontrolliert mit Laserlicht bestrahlt. Der Bereich, in dem der Laserstrahl hin- und herwandern kann, ist durch zwei gestrichelte Linien 5a, 5b gekennzeichnet. Im Behälter 1 befindet sich vor Beginn der Erwärmung Sauerstoff mit einem Druck von 1 Pa ($10^{-5}$ at) oder ein Edelgas, dem Sauerstoff mit einem Partialdruck von 1 Pa zugemischt ist. Bei der für die Texturierung notwendigen Erwärmung und Abkühlung folgt der Sauerstoffpartialdruck im Behälter 1 unter Berücksichtigung der Sauerstoffaufnahme und Sauerstoffabgabe der Oxidschicht 3 ohne weitere Eingriffe von außen dem erforderlichen Druckverlauf, d.h., der erwähnten "optimalen Temperatur - Druck - Beziehung". Bei der Texturierung richten sich die kristallographischen c-Achsen des supraleitenden Materials der Oxidschicht 3 senkrecht zur Oberfläche des Substrats 4 aus.

Der Behälter 6 nach FIG 2 entspricht im Aufbau weitgehend dem Behälter 1 nach FIG 1. Er weist in der oberen Wand ein Fenster 7 auf, durch das ein Laser 8 in den Behälter 6 kontrolliert hineinstrahlt. Der Bereich, in dem der Laserstrahl hin- und herwandern kann, ist durch zwei gestrichelte Linien 8a, 8b gekennzeichnet. Im Behälter 6 befindet sich, wie im Behälter 1, Sauerstoff oder ein Edelgas, dem Sauerstoff zugemischt ist. Vor der Erwärmung durch den Laser 8 beträgt der Sauerstoffpartialdruck auch hier ca. 1 Pa ($10^{-5}$ at). Der Behälter 6 weist zwei einander gegenüberliegende Öffnungen auf, die als Durchführungen 9 und 10 ausgebildet sind. Diese Durchführungen 9 und 10 befinden sich in den beiden Seitenwänden des Behälters 6, die an die obere Wand angrenzen, in der sich das Fenster 7 befindet. Die Durchführungen 9 und 10 sind dabei in der Nähe der der Fensterwand gegenüberliegenden unteren Wand angeordnet. Durch die Durchführungen 9 und 10 ist ein langgestreckter Körper 11, z.B. ein Rohr, eine Stange oder eine Platte durch den Behälter 6 durchführbar. Dichtungen in den Durchführungen 9 und 10 stellen einen gasdichten Abschluß selbst dann sicher, wenn der Körper 11 bewegt wird. Der Körper 11 besteht aus einem Grundkörper 14 aus Metall, der ein Substrat bildet. Auf dem Grundkörper 14 ist eine Oxidschicht 15 aus dem für die Texturierung vorgesehenen Oxid nach Formel (1) angeordnet. Ist der Grundkörper 14 ein Rohr und befindet sich die Oxidschicht 15 auf dessen Innenoberfläche, dann diffundiert der bei Erwärmung freigesetzte Sauerstoff durch die Rohrwand in den Behälter 6. Auch eine im Behälter 6 auf einer Trageplatte 16 gelagerte Substanz 17 gibt Sauerstoff in den Behälter 6 hinein ab. Bei der Abkühlung des Rohres diffundiert dann eine für den erforderlichen Sauerstoffpartialdruck ausreichende Sauerstoffmenge vom Behälter 6 in das Rohr. Bei kontinuierlicher Bewegung des Körpers 11 durch den Behälter 6 hindurch wird durch die Bestrahlung mit Laserlicht in der sauerstoffhaltigen Atmosphäre die Oxidschicht 15 auf der Körper 11 gleichmäßig texturiert. Dabei wird ausgenutzt, daß der Grundkörper 14 wärmeleitend ist. Im Behälter 6 ist zum Beispiel eine heizbare und/oder kühlbare Platte 13 angeordnet, über die hinweg der Körper 11 bewegt werden kann. Die Platte 13 wirkt also als elektrische Zusatzheizung.

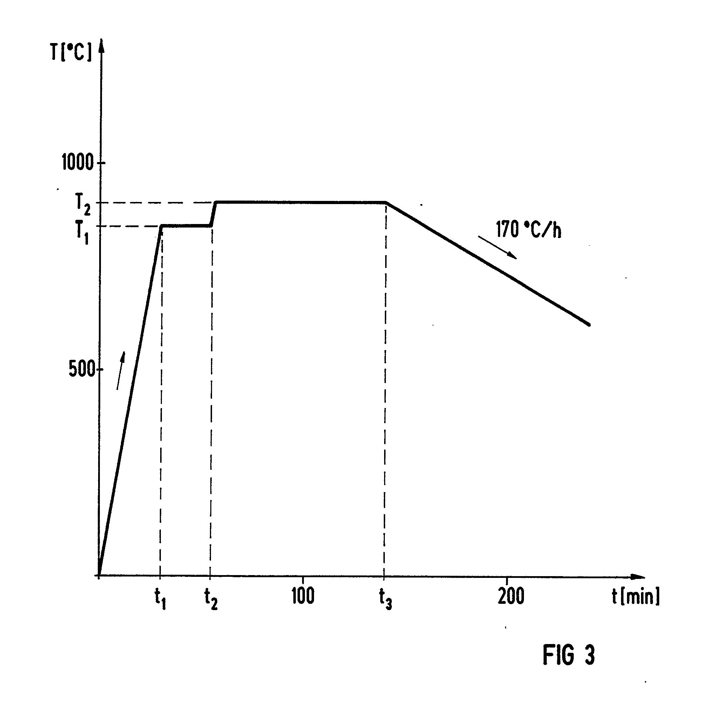

Zum Texturieren wird hochtemperatur-supraleitendes Material nach Formel (1) gemäß Figur 3 von Zimmertemperatur bis zum Zeitpunkt $t_1$ gleichmäßig auf eine Temperatur $T_1$, die zwischen 850°C und 900°C beträgt, erhitzt. Daran schließt sich zwischen den Zeitpunkten $t_1$ und $t_2$ das Aufschmelzen des Materials an. Dabei wird, beispielsweise durch Einstrahlen von Laserlicht, für wenige Sekunden eine Temperatur von über 1000°C erreicht, was maßstabsbedingt in Figur 3 nicht gezeigt ist. Nach dem Zeitpunkt $t_2$ wird das Material über eine Zeitspanne von 1 h bis 1,5 h bei einer Temperatur $T_2$, die etwa 900°C beträgt, geglüht. Das Glühen endet zum Zeitpunkt $t_3$. Die Wärmezufuhr bis zum Zeitpunkt $t_3$ erfolgt beispielsweise durch Laserlicht. Danach wird das Material langsam abgekühlt. Die Abkühlgeschwindigkeit ist beispielsweise 170 $\frac{°C}{h}$. Das Abkühlen wird fortgesetzt bis wie-

der Zimmertemperatur erreicht ist.

**Ansprüche**

1. Verfahren zum Texturieren von hochtemperatur-supraleitendem oxidischen Material (3, 15) in einer Sauerstoff enthaltenden Atmosphäre, **dadurch gekennzeichnet,** daß der Sauerstoffpartialdruck dem zum Texturieren notwendigen Temperaturverlauf nachgeführt wird.

2. Verfahren nach Anspruch 1, **dadurch gekennzeichnet,** daß das Texturieren in einem abgeschlossenen Behälter (1, 6) mit konstantem Volumen erfolgt, in dem sich eine bestimmte Sauerstoffmenge befindet. 3. Verfahren nach einem der Ansprüche 1 oder 2, **dadurch gekennzeichnet,** daß zum Texturieren das Material (3, 15) durch Laserlicht erhitzt wird.

4. Verfahren nach einem der Ansprüche 1 bis 3, **dadurch gekennzeichnet,** daß zum Texturieren das Material (3, 15) zuerst auf eine Temperatur ($T_1$) zwischen 850° C und 900° C erhitzt wird, dann kurzzeitig aufgeschmolzen wird, dann bei einer Temperatur ($T_2$) von etwa 900° C geglüht und danach langsam abgekühlt wird.

5. Einrichtung zum Durchführen des Verfahrens nach einem der Ansprüche 1 bis 4, **gekennzeichnet durch** einen gasdicht verschließbaren, beheizbaren Behälter (1, 6) mit konstantem Volumen, in dem ein hochtemperatur-supraleitendes Material (3, 15) anzuordnen ist, und der mit einem Gas, das eine bestimmte Sauerstoffmenge enthält, füllbar ist.

6. Einrichtung nach Anspruch 5, **dadurch gekennzeichnet,** daß der Behälter (6) zwei gegenüberliegend in Wänden angeordnete abdichtbare Durchführungen (9, 10) aufweist, durch die hindurch ein Körper (11), der supraleitendes Material (15) aufweist, durch den Behälter (6) hindurchführbar ist, und daß in den Durchführungen (9, 10) Dichtungen angeordnet sind zur gasdichten Abdichtung des Behälters (6) gegen den Körper (11).

7. Einrichtung nach einem der Ansprüche 5 oder 6, **dadurch gekennzeichnet,** daß der Behälter (1, 6) in einer Wand angeordnet ein Fenster (2, 7) zum Einstrahlen von Laserlicht aufweist, das von einem Laser (5, 8) ausgeht.

8. Einrichtung nach einem der Ansprüche 5 bis 7, **dadurch gekennzeichnet,** daß im Behälter (1, 6) eine sauerstoffabgebende Substanz (17) vorhanden ist.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ADVANCED CERAMIC MATERIALS, Band 2, Nr. 3B, Juli 1987, Seiten 649-655, ACerS; G. SAGEEV GRADER et al.: "Oxygen stoichiometry in Ba2YCu3Ox, Ba2GdCu3Ox and Ba2EuCu3Ox superconductors as a function of temperature" * Seiten 649-650, Absatz: "Experimental" * --- | 1,2 | H 01 L 39/24 C 04 B 35/00 |
| A | MATERIALS LETTERS, Band 5, Nr. 10, September 1987, Seiten 384-386, Elsevier Science Publishers B.V. (North-Holland Physics Publishing Division); H. QI et al.: "Effects of oxygen content on the lattice distortions and superconductivity in the Y-Ba-Cu-O system" * Insgesamt * --- | 1,2 | |
| A | APPLIED PHYSICS LETTERS, Band 51, Nr. 8, 24. August 1987, Seiten 614-616, American Institute of Physics; R. BEYERS et al.: "Annealing treatment effects on structure and superconductivity in Y1Ba2Cu3O9-x" * Insgesamt * --- | 1,2 | RECHERCHIERTE SACHGEBIETE (Int. Cl.4) H 01 L |
| A | ADVANCED CERAMIC MATERIALS, Band 2, Nr. 3B, Juli 1987, Seiten 444-456, ACerS; G.W. CRABTREE et al.: "Fabrication, mechanical properties, heat capacity, oxygen diffusion, and the effect of alkali earth ion substitution on high Tc superconductors" * Seite 447, Zeile 4 von unten - Seite 448, Zeile 2 * --- -/- | 1,2 | |

Der vorliegende Recherchenbericht wurde für alle Patentansprüche erstellt

| Recherchenort | Abschlußdatum der Recherche | Prüfer |
|---|---|---|
| DEN HAAG | 29-08-1989 | BAILLET B.J.R. |

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ADVANCED CERAMIC MATERIALS, Band 2, Nr. 3B, Juli 1987, Seiten 512-529, ACerS; J.E. BLENDELL et al.: "Processing - property relations for Ba2YCu3O7-x high Tc superconductors" * Seiten 513-514, Absatz: A. "Sample preparation" * --- | 1 | |
| P,X | EP-A-0 293 657 (BATTELLE INSTITUTE e.V.) * Zusammenfassung; Spalte 2, Zeile 29 - Spalte 4, Zeile 31 * ----- | 1,2 | |

RECHERCHIERTE SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 29-08-1989 | BAILLET B.J.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)